# EUROPEAN PATENT SPECIFICATION

(11) **EP 2 270 851 B1**
(45) Date of publication and mention of the grant of the patent: **28.12.2016**
(21) Application number: 08733855.4
(22) Date of filing: 31.03.2008
(51) Int. Cl.: H05K 1/02, H05K 3/46

(54) **METHOD OF BALANCING MULTILAYER SUBSTRATE STRESS AND MULTILAYER SUBSTRATE**
VERFAHREN ZUM AUSGLEICH VON SPANNUNGEN IN EINEM MEHRSCHICHTIGEN SUBSTRAT UND MEHRSCHICHTIGES SUBSTRAT
PROCEDE D'EQUILIBRAGE DE CONTRAINTE DE SUBSTRAT MULTICOUCHE ET SUBSTRAT MULTICOUCHE

(43) Date of publication of application: 05.01.2011
(73) Proprietor: Princo Corp., Taiwan (CN)
(72) Inventor: YANG, Chih-kuang, Taiwan (CN)
(74) Representative: Perani, Aurelio
(86) International application number: PCT/CN2008/000630
(87) International publication number: WO 2009/121200

(56) References cited:
- CN-A- 1 400 661
- CN-A- 1 494 133
- CN-A- 1 797 726
- JP-A- 8 288 316
- JP-A- 11 017 064
- JP-A- 2004 200 265
- US-A- 5 888 630
- US-A1- 2006 024 921
- US-B1- 6 380 633

## Description

### BACKGROUND OF THE INVENTION

### 1. Field of the Invention

The present invention generally relates to a method to decrease warpage of a multi-layer substrate, and more particularly to a method of balancing a flexible multi-layer substrate stress to decrease warpage or twist of the multi-layer substrate for stresses generated by occupied area differences and occupied location differences of different metal layers and dielectric layers.

### 2. Description of Prior Art

A multi-layer substrate today may employ coating method to form a plurality of dielectric layers and corresponding metal layers between these dielectric layers are formed by lithography process. The aforesaid dielectric layers and metal layers are alternately stacked-up to realize the aforementioned multi-layer substrate having advantage of thin thickness and simple materials. Moreover, such coating method can be significantly suitable for manufacturing flexible multi-layer substrate.

The wet films were formed by the dielectric layers coating method, therefore, the steps of drying these dielectric layers to be hardened thereof, are needed hereafter. Different metal layers have different areas and different locations because of respective circuit designs. Accordingly, dielectric layers corresponding to different metal layers may have different areas, also. After the metal layers and the dielectric layers are stacked-up and the aforesaid drying and hardening process are proceeded, shrinkage rates of respective dielectric layers may be different (although all dielectric layers' materials are the same, the shrinkage rates can be different due to respective shapes, occupied areas and volumes). Consequently, stresses become unbalanced between some metal layers and some dielectric layers to result in warpage or twist of the multi-layer substrate. Even the dielectric layers that are not formed by the coating method, unbalanced stress can cause warpage or twist of the multi-layer substrate that happens because of different volumes, thicknesses materials, or constructions of different metal layers and dielectric layers. US 5.888,630 A. US 6,380,633 B1 and JP 2004-200265 A and related prior arts for this field.

The aforesaid warpage or twist can seriously influence precision of whole system assembly later on, even unable to assembly the whole system. Furthermore, speaking of design application of a flexible multi-layer substrate, foldable characteristic is the major purpose of developing the flexible multi-layer substrate industry. After the flexible multi-layer substrate is applied into productions, some specific areas, even the entire substrate can be bent frequently. If the stress, warpage or twist problems of the multi-layer substrate are not solved, the lifetime of the production can be shorter and cannot be commercialized.

### SUMMARY OF THE INVENTION

An objective of the present invention is to provide a method to decrease warpage of a flexible multi-layer substrate by balancing a multi-layer substrate stress generated by occupied area differences and occupied location differences of different metal layers and dielectric layers.

For accomplishing aforesaid objective of the present invention, the present invention employs a method according to claim 1 and a flexible multi-layer substrate structure accordance to claim 4 or claim 5. The multi-layer substrate has a first metal layer and a second metal layer at least and a first area of the first metal layer is larger than a second area of the second metal layer, wherein at least one redundant metal layer is set in the same layer of the second metal layer so that a redundant metal layer area plus the second area is considerably equivalent to the first area. The redundant metal layer and the second metal layer are positioned corresponding to the first metal layer which is subject to a central plane which is parallel with the first metal layer and the second metal layer. Furthermore, the method to decrease warpage according to the present invention can still be functional when a third metal layer is located between the first metal layer and the second metal layer.

Moreover, when a first surface dielectric layer located at a first surface of the multi-layer substrate has at least one opening, the second surface dielectric layer located at a second surface of the multi-layer substrate can be set at least one redundant opening positioned corresponding to the at least one opening. According to the present invention, stresses caused by different occupied areas and locations of different metal layers and dielectric layers can be balanced, i.e. homogenizing occupied areas and locations of different metal layers and dielectric layers to decrease warpage or twist of the multi-layer substrate.

### BRIEF DESCRIPTION OF THE DRAWINGS

FIG. 1 depicts a diagram of a first embodiment to decrease warpage of a multi-layer substrate according to the present invention.
FIG. 2 depicts a diagram of a second embodiment to decrease warpage of a multi-layer substrate according to the present invention.
FIG. 3 depicts a diagram of a third embodiment to decrease warpage of a multi-layer substrate according to the present invention.
FIG. 4 depicts a diagram of a fourth embodiment to decrease warpage of a multi-layer substrate according to the present invention.
FIG. 5 depicts a diagram of a fifth embodiment to decrease warpage of a multi-layer substrate according to the present invention.

### DETAILED DESCRIPTION OF THE INVENTION

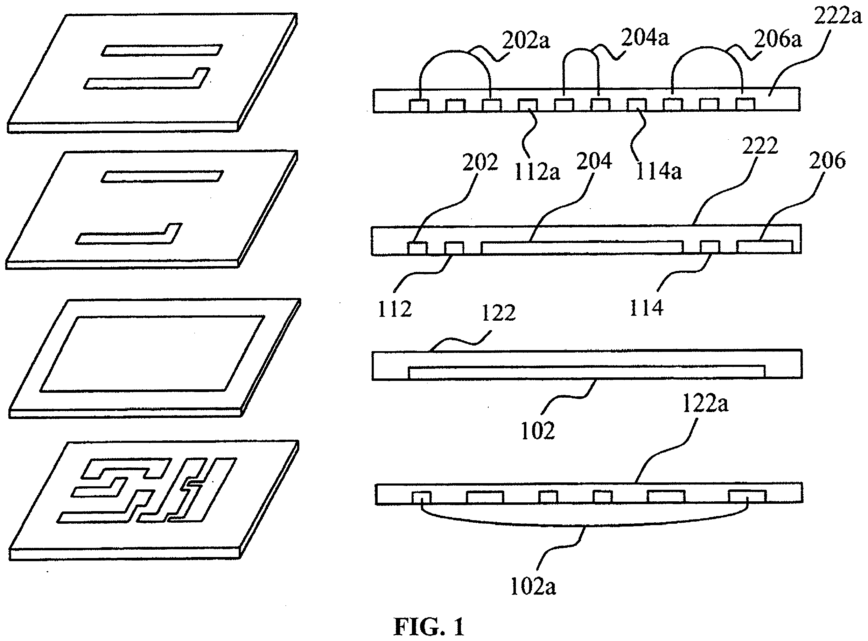

Please refer to FIG. 1, which depicts a diagram of a first embodiment to decrease warpage of a multi-layer substrate according to the present invention. On the left side of FIG. 1, a three dimensional view of a multi-layer substrate is shown and a corresponding profile drawing is shown on the right side. The multi-layer substrate comprises a first metal layer 102, a first dielectric layer 122 corresponding thereto, second metal layers 112, 114 and a second dielectric layer 222 corresponding thereto.

As aforementioned, the first dielectric layer 122 and the second dielectric layer 222 are formed by a coating method. The aforesaid drying and hardening process is proceeded, and shrinkage rates of respective dielectric layers may be different. Stresses become unbalanced between some metal layers and dielectric layers to result in warpage of the multi-layer substrate. Moreover, even the dielectric layers are not formed by the coating method, unbalanced stress between the metal layers and dielectric layers of the multi-layer substrate are making warpage thereof to happen because of different volumes, thicknesses, materials, or constructions of different metal layers and dielectric layers. Therefore, the present invention can be employed to homogenize the multi-layer structure composed of different metal layers and dielectric layers as shown in FIG. 1.

Because an area of the first metal layer 102 occupies most of the multi-layer substrate and is larger than an area of the second metal layers 112 and 114. Therefore, in the same layer of the second metal layers 112 and 114, redundant metal layers 202, 204 and 206 can be set on the premise that circuit design is not affected. The second area plus the redundant metal layer area is considerably equivalent to the first area. Moreover, the redundant metal layers 202, 204 and 206 and the second metal layer 112, 114 are positioned corresponding to the first metal layer 102 which is subject to a hypothetical central plane which is parallel with the first metal layer 102 and the second metal layer 112, 114. Accordingly, stress of the multi-layer substrate can be balanced to prevent warpage happening.

As shown in FIG. 1, the multi-layer substrate may further comprise a fourth metal layer 102a, a fourth dielectric layer 122a corresponding thereto, fifth metal layers 112a, 114a and fifth dielectric layer 222a corresponding thereto. The fourth metal layer 102a is located at outer side of the first metal layer 102; the fifth metal layers 112a, 114a are located at outer side of the second metal layers 112 and 114. As the fourth metal layer 102a is larger then the fifth metal layers 112a, 114a. Similarly, fifth redundant metal layers 202a, 204a and 206a can be set in the same layer of the fifth metal layers 112a, 114a on the premise that circuit design is not affected. The fifth redundant metal layer area plus the fifth area is considerably equivalent to the fourth area. Moreover, the fifth redundant metal layers 202a, 204a and 206a and the fifth metal layers 112a, 114a are positioned corresponding to the fourth metal layer 102a which is subject to a hypothetical central plane which is parallel with the fourth metal layer 102a and the fifth metal layers 112a, 114a.

With overall consideration for the multi-layer substrate, no matter the two metal layers positioned corresponding to each other are adjacent with each other or not, making the inner of the multi-layer substrate as symmetrical structures described as the first metal layer 102 and the second metal layer 112, 114; as the fourth metal layer 102a and the fifth metal layers 112a, 114a, stresses of the multi-layer substrate can be balanced to decrease warpage thereof. Alternatively, as the fourth metal layer 102a is located at inner side of the first metal layer 102; the fifth metal layers 112a, 114a are located at inner side of the second metal layers 112 and 114, the present invention can still work for balancing stress of the multi-layer substrate, therefore, decreasing warpage of the multi-layer substrate.

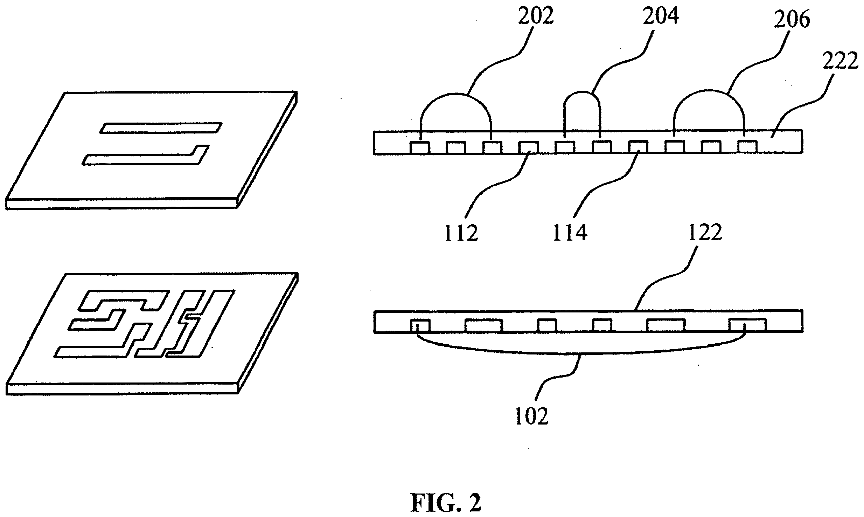

Please refer to FIG. 2, which depicts a diagram of a second embodiment to decrease warpage of a multi-layer substrate according to the present invention. Similarly, on the left side of FIG. 2, a three dimensional view of a multi-layer substrate is shown and a corresponding profile drawing is shown on the right side. The multi-layer substrate comprises a first metal layer 102, a first dielectric layer 122 corresponding thereto, second metal layers 112, 114 and a second dielectric layer 222 corresponding thereto.

In this embodiment, pattern of the first metal layer 102 is complex but occupied area thereof is still larger than area of the second metal layers 112, 114. Therefore, in the same layer of the second metal layers 112 and 114, small, distributed redundant metal layers 202, 204 and 206 can be set on the premise that circuit design is not affected. The purpose is that the redundant metal layer area plus the second area remains considerably equivalent to the first area. Moreover, the redundant metal layers 202, 204 and 206 and the second metal layer 112, 114 are positioned corresponding to the first metal layer 102 which is subject to a hypothetical central plane which is parallel with the first metal layer 102 and the second metal layer 112, 114. Accordingly, stress of the multi-layer substrate can be balanced to decrease warpage happening.

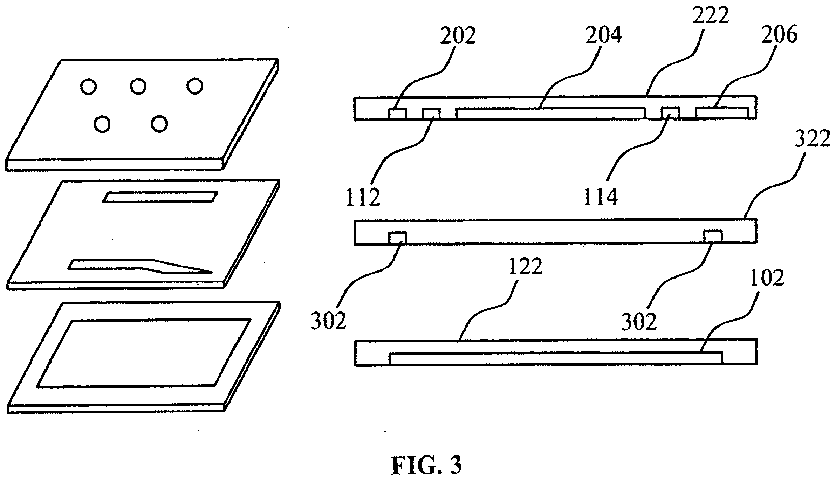

Please refer to FIG. 3, which depicts a diagram of a third embodiment to decrease warpage of a multi-layer substrate according to the present invention. Similarly, on the left side of FIG. 3, a three dimensional view of a multi-layer substrate is shown and a corresponding profile drawing is shown on the right side. The multi-layer substrate comprises a first metal layer 102, a first dielectric layer 122 corresponding thereto, second metal layers 112, 114 and a second dielectric layer 222 corresponding thereto.

Furthermore, the multi-layer substrate can further comprise a third metal layer 302 and a third dielectric layer 322 corresponding thereto between the first metal layer 102 and the second metal layers 112, 114. The occupied area of the third metal layer 302 can be smaller than both areas of the first metal layer 102 and the second metal layers 112, 114. Therefore, consideration of area of the third metal layer 302 therebetween can be ignored but occupied areas locations differences of the first metal layer 102 and the second metal layers 112, 114.

As aforementioned, as making the inner of the multi-layer substrate as symmetrical structures with overall considering the multi-layer substrate, therefore, the present invention can set smaller redundant metal layers 202, 206 and a larger redundant metal layer 204 in the same layer of the second metal layers 112 and 114 on the premise that circuit design is not affected. The purpose is that the redundant metal layer area plus the second area remains considerably equivalent to the first area. Moreover, the redundant metal layers 202, 204 and 206 and the second metal layer 112, 114 are positioned corresponding to the first metal layer 102 which is subject to a hypothetical central plane which is parallel with the first metal layer 102 and the second metal layer 112, 114. Accordingly, stress of the multi-layer substrate can be balanced to prevent warpage happening.

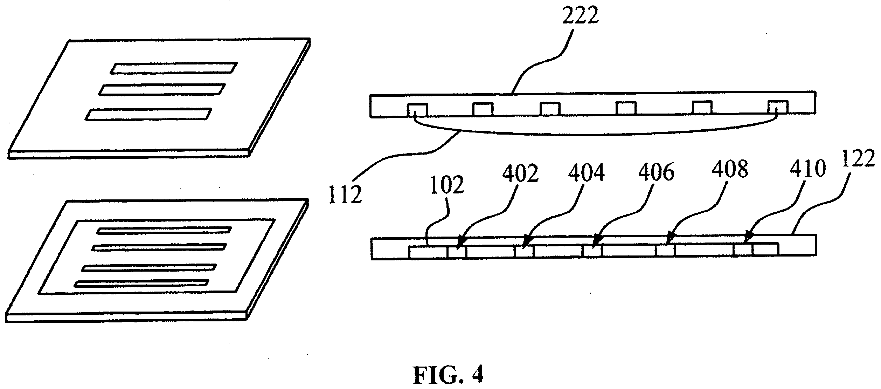

Please refer to FIG. 4, which depicts a diagram of a fourth embodiment to decrease warpage of a multi-layer substrate according to the present invention. Similarly, on the left side of FIG. 4, a three dimensional view of a multi-layer substrate is shown and a corresponding profile drawing is shown on the right side. The multi-layer substrate comprises a first metal layer 102, a first dielectric layer 122 corresponding thereto, second metal layers 112, 114 and a second dielectric layer 222 corresponding thereto.

Occupied area of the first metal layer 102 is larger than area of the second metal layers 112, 114. However, what is different from the aforesaid embodiments is that redundant spaces 402, 404, 406, 408 and 410 can be set in the first metal layer 102 so that first area of the first metal layer 102 subtracting redundant space areas is considerably equivalent to the second area of the second metal layers 112, 114. Besides, the first metal layer 102 subtracting redundant spaces is positioned corresponding to the second metal layer 112 which is subject to a hypothetical central plane which is parallel with the first metal layer 102 and the second metal layer 112. Accordingly, balancing stress of the multi-layer substrate to decrease warpage thereof can be realized. In this embodiment, certainly as similar as described in aforesaid embodiment, the multi-layer substrate may further comprise a fourth metal layer located at inner side or outer side of the of the first metal layer 102; and, the fifth metal layer located at inner side or outer side of the second metal layers 112 and 114. As the fourth metal layer is larger then the fifth metal layers. A fourth redundant space can be set in the fourth metal layer to make the inner of the multi-layer substrate as symmetrical structures. No matter corresponding metal layers are adjacent or not, stress of the multi-layer substrate can be balanced and warpage happening to the multi-layer substrate can be decreased.

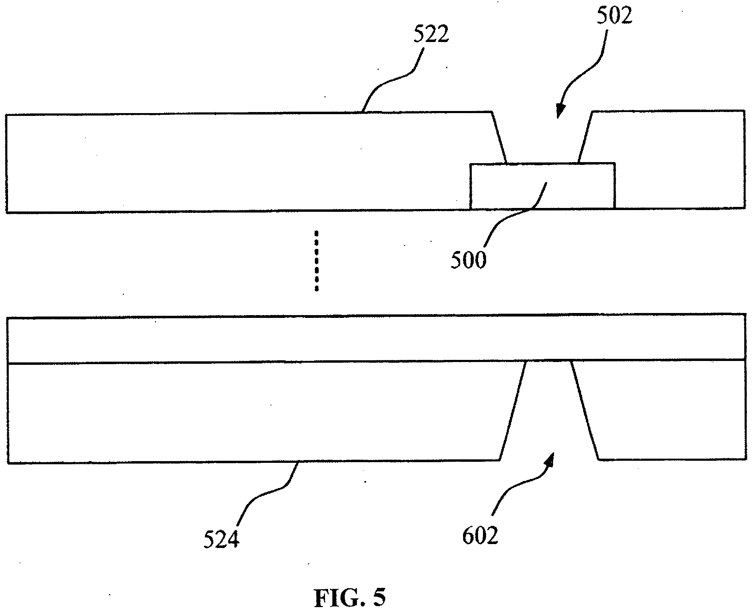

Please refer to FIG. 5, which depicts a diagram of a fifth embodiment to decrease warpage of a multi-layer substrate according to the present invention. As shown in FIG. 5, the multi-layer substrate has an opening 502 in the first surface dielectric layer 522 located at a first surface of the multi-layer substrate at the position of a pad 500. The multi-layer substrate also has a second surface dielectric layer 524 located at a second surface of the multi-layer substrate. With concept of homogenize the multi-layer structure composed of different metal layers and dielectric layers according to the present invention, a redundant opening 602 can be set corresponding to the opening 502 positionally to balance stress of the multi-layer substrate to decrease warpage thereof. Similarly, if the opening 502 is in the inner of the multi-layer substrate, a redundant opening positioned corresponding to the opening 502 still can be set with overall considering the structure of the multi-layer substrate. The stress of the multi-layer substrate still can be balanced and decreasing warpage of the multi-layer substrate still can be realized.

In conclusion, the first to fifth embodiments can be exercised alone or in combination for matching different electric circuit designs when a multi-layer substrate is manufactured. Homogenization for occupied areas and locations of different metal layers and dielectric layers in the multi-layer substrate can be achieved to decrease warpage or twist of the multi-layer substrate.

## Claims

1. A method to decrease warpage of a flexible multi-layer substrate, **characterized in that** said method comprises:
providing a first dielectric layer (522) in the flexible multi-layer substrate that the first dielectric layer (522) has at least one opening (502); and
providing a second dielectric layer (524) in the flexible multi-layer substrate,
wherein the second dielectric layer (524) has at least one redundant opening (602) positioned corresponding to the at least one opening (502) with respect to a symmetric plane lying parallel to the first dielectric layer (522) and the second dielectric layer (524) to homogenize the flexible multi-layer substrate composed of the first dielectric layer (522), the second dielectric layer (524), the opening (502), and the redundant opening (602); and
wherein the fist dielectric layer (522) is a first surface dielectric layer and the second dielectric layer (524) is a second surface dielectric layer.

2. The method according to claim 1, **characterized in that** the flexible multi-layer substrate comprises a first metal layer (102) and a second metal layer (112, 114), a first area of the first metal layer (102) is larger than a second area of the second metal layer (112, 114), and said method comprises:
setting at least one redundant metal layer (202, 204, 206) in the same layer of the second metal layer (112, 114) so that a redundant metal layer area plus the second area is considerably equivalent to the first area, wherein the redundant metal layer (202, 204, 206) and the second metal layer (112, 114) are positioned corresponding to the first metal layer (102) with respect to a symmetric plane lying parallel to the first metal layer (102) and the second metal layer (112, 114) to homogenize the multi-layer structure composed of the first metal layer (102), the second metal layer (112, 114), and the redundant metal layer (202, 204, 206).

3. The method according to claim 1, **characterized in that** the flexible multi-layer substrate comprises a first metal layer (102) and a second metal layer (112, 114), a first area of the first metal layer (102) is larger than a second area of the second metal layer (112, 114), and said method comprises:
setting at least one redundant space (402, 404, 406, 408, 410) in the first metal layer (102) so that the first area subtracting a redundant space area is considerably equivalent to the second area, wherein the second metal layer (112, 114) is positioned corresponding to the first metal layer (102) except the redundant space (402, 404, 406, 408, 410) with respect to a symmetric plane lying parallel to the first metal layer (102) and the second metal layer (112, 114) to homogenize the multi-layer structure composed of the first metal layer (102), the second metal layer (112, 114), and the redundant space (402, 404, 406, 408, 410).

4. A flexible multi-layer substrate structure, comprising a first metal layer (102) and a second metal layer (112, 114), a first area of the first metal layer (102) is larger than a second area of the second metal layer (112, 114), **characterized in that** said flexible multi-layer substrate structure comprises:
at least one redundant metal layer (202, 204, 206) set in the same layer of the second metal layer (112, 114) so that a redundant metal layer area plus the second area is considerably equivalent to the first area, wherein the redundant metal layer (202, 204, 206) and the second metal layer (112, 114) are positioned corresponding to the first metal layer (102) with respect to a symmetric plane lying parallel to the first metal layer (102) and the second metal layer (112, 114) to homogenize the multi-layer structure composed of the first metal layer (102), the second metal layer (112, 114), and the redundant metal layer (202, 204, 206);
wherein the flexible multi-layer substrate structure further comprises a first surface dielectric layer (522) located at a first surface of the flexible multi-layer substrate structure that the first surface dielectric layer (522) has at least one opening (502); and
wherein the flexible multi-layer substrate structure further comprises a second surface dielectric layer (524) located at a second surface of the flexible multi-layer substrate structure that the second surface dielectric layer (524) has at least one redundant opening (602) positioned corresponding to the at least one opening (502).

5. A flexible multi-layer substrate structure, comprising a first metal layer (102) and a second metal layer (112, 114), a first area of the first metal layer (102) is larger than a second area of the second metal layer (112, 114), **characterized in that** said flexible multi-layer substrate structure comprises:
at least one redundant space (402, 404, 406, 408, 410) set in the first metal layer (102) so that the first area subtracting a redundant space area is considerably equivalent to the second area, wherein the second metal layer (112, 114) is positioned corresponding to the first metal layer (102) except the redundant space (402, 404, 406, 408, 410) with respect to a symmetric plane lying parallel to the first metal layer (102) and the second metal layer (112, 114) to homogenize the multi-layer structure composed of the first metal layer (102), the second metal layer (112, 114), and the redundant space (402, 404, 406, 408, 410);
wherein the flexible multi-layer substrate structure further comprises a first surface dielectric layer (522) located at a first surface of the flexible multi-layer substrate structure that the first surface dielectric layer (522) has at least one opening (502); and
wherein the flexible multi-layer substrate structure further comprises a second surface dielectric layer (524) located at a second surface of the flexible multi-layer substrate structure that the second surface dielectric layer (524) has at least one redundant opening (602) positioned corresponding to the at least one opening (502).

## Patentansprüche

1. Verfahren, zur Reduzierung der Verwerfung eines flexiblen mehrschichtigen Substrats, **dadurch gekennzeichnet, dass** das Verfahren umfasst:
Bereitstellen einer ersten dielektrischen Schicht (522) in dem flexiblen mehrschichtigen Substrat derart, dass die erste dielektrische Schicht (522) mindestens eine Öffnung (502) aufweist, und
Bereitstellen einer zweiten dielektrischen Schicht (524) in dem flexiblen mehrschichtigen Substrat,
wobei die zweite dielektrische Schicht (524) min destens eine redundante Öffnung (602) aufweist, die in Bezug auf eine Symmetrieebene, die parallel zu der ersten dielektrischen Schicht (522) und der zweiten dielektrischen Schicht (524) verläuft, der mindestens einen Öffnung (502) entsprechend positioniert wird, um das flexible mehrschichtige Substrat, das aus der ersten dielektrischen Schicht (522), der zweiten dielektrischen Schicht (524), der Öffnung (502) und der redundanten Öffnung (602) zusammengesetzt ist, zu homogenisieren, und
wobei die erste dielektrische Schicht (522) eine erste dielektrische Oberflächenschicht ist und die zweite dielektrische Schicht (524) eine zweite dielektrische Oberflächenschicht ist.

2. Verfahren nach Anspruch 1, **dadurch gekennzeichnet, dass** das flexible mehrschichtige Substrat eine erste Metallschicht (102) und eine zweite Metallschicht (112, 114) umfasst, eine erste Fläche der ersten Metallschicht (102) größer als eine zweite Fläche der zweiten Metallschicht (112, 114) ist und das Verfahren umfasst:
Anordnen mindestens einer redundanten Metallschicht (202, 204, 206) in derselben Schicht der zweiten Metallschicht (112, 114) derart, dass eine Fläche von redundanten Metallschichten zuzüglich der zweiten Fläche im Wesentlichen äquivalent der ersten Fläche ist, wobei die redundante Metallschicht (202, 204, 206) und die zweite Metallschicht (112, 114) in Bezug auf eine Symmetrieebene, die parallel zu der ersten Metallschicht (102) und der zweiten Metallschicht (112, 114) verläuft, der ersten Metallschicht (102) entsprechend positioniert werden, um die mehrschichtige Konstruktion, die aus der ersten Metallschicht (102), der zweiten Metallschicht (112, 114) und der redundanten Metallschicht (202, 204, 206) zusammengesetzt ist, zu homogenisieren.

3. Verfahren nach Anspruch 1, **dadurch gekennzeichnet, dass** das flexible mehrschichtige Substrat eine erste Metallschicht (102) und eine zweite Metallschicht (112, 114) umfasst, eine erste Fläche der ersten Metallschicht (102) größer als eine zweite Fläche der zweiten Metallschicht (112, 114) ist und das Verfahren umfasst:
Anordnen mindestens eines redundanten Raums (402, 404, 406, 408, 410) in der ersten Metallschicht (102), derart, dass die erste Fläche abzüglich einer Fläche redundanter Räume im Wesentlichen äquivalent einer zweiten Fläche ist, wobei die zweite Metallschicht (112, 114) in Bezug auf eine Symmetrieebene, die parallel zu der ersten Metallschicht (102) und der zweiten Metallschicht (112, 114) verläuft, der ersten Metallschicht (102) entsprechend, den redundanten Raum (402, 404, 406, 408, 410) ausgenommen, positioniert wird, um die mehrschichtige Konstruktion, die aus der ersten Metallschicht (102), der zweiten Metallschicht (112, 114) und dem redundanten Raum (402, 404, 406, 408, 410) zusammengesetzt ist, zu homogenisieren.

4. Flexible mehrschichtige Substratkonstruktion, umfassend eine erste Metallschicht (102) und eine zweite Metallschicht (112, 114), wobei eine erste Fläche der ersten Metallschicht (102) größer als eine zweite Fläche der zweiten Metallschicht (112, 114) ist, **dadurch gekennzeichnet, dass** die flexible mehrschichtige Substratkonstruktion umfasst:
mindestens eine redundante Metallschicht (202, 204, 206), die in derselben Schicht wie die zweite Metallschicht (112, 114) angeordnet ist, derart, dass eine Fläche von redundanten Metallschichten zuzüglich der zweiten Fläche im Wesentlichen äquivalent der ersten Fläche ist, wobei die redundante Metallschicht (202, 204, 206) und die zweite Metallschicht (112, 114) in Bezug auf eine Symmetrieebene, die parallel zu der ersten Metallschicht (102) und der zweiten Metallschicht (112, 114) verläuft, der ersten Metallschicht (102) entsprechend positioniert sind, um die mehrschichtige Konstruktion, die aus der ersten Metallschicht (102), der zweiten Metallschicht (112, 114) und der redundanten Metallschicht (202, 204, 206) zusammengesetzt ist, zu homogenisieren,
wobei die flexible mehrschichtige Substratkonstruktion ferner eine erste dielektrische Oberflächenschicht (522) umfasst, die an einer ersten Oberfläche der flexiblen mehrschichtigen Substratstruktur angeordnet ist, derart, dass die erste dielektrische Oberflächenschicht (522) mindestens eine Öffnung (502) aufweist, und
wobei die flexible mehrschichtige Substratkonstruktion ferner eine zweite dielektrische Oberflächenschicht (524) umfasst, die an einer zweiten Oberfläche der flexiblen mehrschichtigen Substratstruktur angeordnet ist, derart, dass die zweite dielektrische Oberflächenschicht (524) mindestens eine redundante Öffnung (602) aufweist, die der mindestens einen Öffnung (502) entsprechend positioniert ist.

5. Flexible mehrschichtige Substratkonstruktion, umfassend eine erste Metallschicht (102) und eine zweite Metallschicht (112, 114), wobei eine erste Fläche der ersten Metallschicht (102) größer als eine zweite Fläche der zweiten Metallschicht (112, 114) ist, **dadurch gekennzeichnet, dass** die flexible mehrschichtige Substratkonstruktion umfasst:
mindestens einen redundanten Raum (402, 404, 406, 408, 410), der in der ersten Metallschicht (102) angeordnet ist, derart, dass die erste Fläche abzüglich einer Fläche redundanter Räume im Wesentlichen äquivalent der zweiten Fläche ist, wobei die zweite Metallschicht (112, 114) in Bezug auf eine Symmetrieebene, die parallel zu der ersten Metallschicht (102) und der zweiten Metallschicht (112, 114) verläuft, der ersten Metallschicht (102) entsprechend, den redundanten Raum (402, 404, 406, 408, 410) ausgenommen, positioniert ist, um die mehrschichtige Konstruktion, die aus der ersten Metallschicht (102), der zweiten Metallschicht (112, 114) und dem redundanten Raum (402, 404, 406, 408, 410) zusammengesetzt ist, zu homogenisieren,
wobei die flexible mehrschichtige Substratkonstruktion ferner eine erste dielektrische Oberflächenschicht (522) umfasst, die an einer ersten Oberfläche der flexiblen mehrschichtigen Substratkonstruktion angeordnet ist, derart, dass die erste dielektrische Oberflächenschicht (522) mindestens eine Öffnung (502) aufweist, und
wobei die flexible mehrschichtige Substratkonstruktion ferner eine zweite dielektrische Oberflächenschicht (524) umfasst, die an einer zweiten Oberfläche der flexiblen mehrschichtigen Substratkonstruktion angeordnet ist, derart, dass die zweite dielektrische Oberflächenschicht (524) mindestens eine redundante Öffnung (602) aufweist, die der mindestens einen Öffnung (502) entsprechend positioniert ist.

## Revendications

1. Procédé de réduction de la déformation d'un substrat multicouche souple, **caractérisé en ce que** ledit procédé comprend :
la mise à disposition d'une première couche diélectrique (522) dans le substrat multicouche souple, la première couche diélectrique (522) présentant au moins une ouverture (502), et
la mise à disposition d'une deuxième couche diélectrique (524) dans le substrat multicouche souple,
dans lequel la deuxième couche diélectrique (524) présente au moins une ouverture redondante (602) positionnée en correspondance avec l'au moins une ouverture (502) par rapport à un plan symétrique s'étendant parallèlement à la première couche diélectrique (522) et à la deuxième couche diélectrique (524) pour homogénéiser le substrat multicouche souple composé de la première couche diélectrique (522), de la deuxième couche diélectrique (524), de l'ouverture (502) et de l'ouverture redondante (602), et
dans lequel la première couche diélectrique (522) est une première couche diélectrique de surface et la deuxième couche diélectrique (524) est une deuxième couche diélectrique de surface.

2. Procédé selon la revendication 1, **caractérisé en ce que** le m comprend une première couche métallique (102) et une deuxième couche métallique (112, 114), une première zone de la première couche métallique (102) étant plus grande qu'une deuxième zone de la deuxième couche métallique (112, 114), et ledit procédé comprenant :
l'ajustement d'au moins une couche métallique redondante (202, 204, 206) dans la même couche de la deuxième couche métallique (112, 114), de telle façon qu'une zone de couche métallique redondante plus la deuxième zone sont considérablement équivalentes à la première zone, la couche métallique redondante (202, 204, 206) et la deuxième couche métallique (112, 114) étant positionnées en correspondance avec la première couche métallique (102) par rapport à un plan symétrique s'étendant parallèlement à la première couche métallique (102) et à la deuxième couche métallique (112, 114) pour homogénéiser la structure multicouche composée de la première couche métallique (102), de la deuxième couche métallique (112, 114) et de la couche métallique redondante (202, 204, 206).

3. Procédé selon la revendication 1, **caractérisé en ce que** le substrat multicouche souple comprend une première couche métallique (102) et une deuxième couche métallique (112, 114), une première zone de la première couche métallique (102) étant plus grande qu'une deuxième zone de la deuxième couche métallique (112, 114), et ledit procédé comprenant :
l'ajustement d'au moins un espace redondant (402, 404, 406, 408, 410) dans la première couche métallique (102), de telle façon que la première zone moins un espace redondant est considérablement équivalente à la deuxième zone, la deuxième couche métallique (112, 114) étant positionnée en correspondance avec la première couche métallique (102) à l'exception de l'espace redondant (402, 404, 406, 408, 410) par rapport à un plan symétrique s'étendant parallèlement à la première couche métallique (102) et à la deuxième couche métallique (112, 114) pour homogénéiser la structure multicouche composée de la première couche métallique (102), de la deuxième couche métallique (112, 114) et de l'espace redondant (402, 404, 406, 408, 410).

4. Structure de substrat multicouche souple comprenant une première couche métallique (102) et une deuxième couche métallique (112, 114), une première zone de la première couche métallique (102) étant plus grande qu'une deuxième zone de la deuxième couche métallique (112, 114), **caractérisée en ce que** ladite structure de substrat multicouche souple comprend :
Au moins une couche métallique redondante (202, 204, 206) ajustée dans le même plan de la deuxième couche métallique (112, 114), de sorte qu'une zone de couche métallique redondante plus la deuxième zone est considérablement équivalente à la première zone, la couche métallique redondante (202, 204, 206) et la deuxième couche métallique (112, 114) étant positionnées en correspondance avec la première couche métallique (102) par rapport à un plan symétrique s'étendant parallèlement à la première couche métallique (102) et à la deuxième couche métallique (112, 114) pour homogénéiser la structure multicouche composée de la première couche métallique (102), de la deuxième couche métallique (112, 114) et de la couche métallique redondante (202, 204, 206),
dans laquelle la structure de substrat multicouche souple comprend en outre une première couche diélectrique de surface (522) située sur une première surface de la structure de substrat multicouche souple, la première couche diélectrique de surface (522) présentant au moins une ouverture (502), et
dans laquelle la structure de substrat multicouche souple comprend en outre une deuxième couche diélectrique de surface (524) située sur une deuxième surface de la structure de substrat multicouche souple, la deuxième couche diélectrique de surface (524) présentant au moins une ouverture redondante (602) positionnée en correspondance avec l'au moins une ouverture (502).

5. Structure de substrat multicouche souple comprenant une première couche métallique (102) et une deuxième couche métallique (112, 114), une première zone de la première couche métallique (102) étant plus grande qu'une deuxième zone de la deuxième couche métallique (112, 114), **caractérisée en ce que** ladite structure de substrat multicouche souple comprend :
au moins un espace redondant (402, 404, 406, 408, 410) ajusté dans la première couche métallique (102), de sorte que la première zone moins une zone d'espace redondant est considérablement équivalente à la deuxième zone, la deuxième couche métallique (112, 114) étant positionnée en correspondance avec la première couche métallique (102) à l'exception de l'espace redondant (402, 404, 406, 408, 410) par rapport à un plan symétrique s'étendant parallèlement à la première couche métallique (102) et à la deuxième couche métallique (112, 114) pour homogénéiser la structure multicouche composée de la première couche métallique (102), de la deuxième couche métallique (112, 114) et de l'espace redondant (402, 404, 406, 408, 410),
dans laquelle la structure de substrat multicouche souple comprend en outre une première couche diélectrique de surface (522) située sur une première surface de la structure de substrat multicouche souple, la première couche diélectrique de surface (522) présentant au moins une ouverture (502), et
dans laquelle la structure de substrat multicouche souple comprend en outre une deuxième couche diélectrique de surface (524) située sur une deuxième surface de la structure de substrat multicouche souple, la deuxième couche diélectrique de surface (524) présentant au moins une ouverture redondante (602) positionnée en correspondance avec l'au moins une ouverture (502).
